Europäisches Patentamt

European Patent Office

Office européen des brevets

(11) Veröffentlichungsnummer: **0 156 005**
**A1**

# (12) EUROPÄISCHE PATENTANMELDUNG

(21) Anmeldenummer: **84114710.1**

(22) Anmeldetag: **04.12.84**

(51) Int. Cl.⁴: **G 01 R 31/28**
**H 01 J 37/26**

(30) Priorität: **27.02.84 DE 3407071**

(43) Veröffentlichungstag der Anmeldung:
**02.10.85 Patentblatt 85/40**

(84) Benannte Vertragsstaaten:
**DE FR GB IT NL**

(71) Anmelder: **Siemens Aktiengesellschaft**
**Berlin und München Wittelsbacherplatz 2**
**D-8000 München 2(DE)**

(72) Erfinder: **Feuerbaum, Hans-Peter, Dr.-Ing., Dipl.-Phys.**
**Arno-Assmann-Strasse 14**
**D-8000 München 83(DE)**

(72) Erfinder: **Fazekas, Peter, Dipl.-Ing.**
**Stuntzstrasse 21**
**D-8000 München 80(DE)**

(54) **Verfahren zur automatischen Einstellung der Spannungsauflösung in Korpuskularstrahl-Messgeräten und Vorrichtung zur Durchführung eines solchen Verfahrens.**

(57) Mit einem Verfahren zur Einstellung der Spannungsauflösung in Korpuskularstrahl-Meßgeräten, bei dem die Bandbreite der Meßsignal-Verarbeitung verändert wird, soll eine
gewünschte Spannungsauflösung einfach, zuverlässig und
mit hoher Genauigkeit eingestellt werden können. Zu diesem
Zweck wird das Signalrauschen im Meßsignal gemessen.
Dieses Signalrauschen wird mit einem gewünschten Wert (S)
für die Meßsignal-Auflösung verglichen und die Bandbreite
der Meßsignal-Verarbeitung wird so verändert, daß das Signalrauschen des Meßsignals kleiner oder gleich dem
gewünschten Wert (S) für die Meßsignal-Auflösung ist.

EP 0 156 005 A1

Croydon Printing Company Ltd

SIEMENS AKTIENGESELLSCHAFT          Unser Zeichen          0156005
Berlin und München                  VPA   84 P 1 155 E

Verfahren zur automatischen Einstellung der Spannungsauflösung in Korpuskularstrahl-Meßgeräten und Vorrichtung zur
Durchführung eines solchen Verfahrens.

Die Erfindung betrifft ein Verfahren zur automatischen Einstellung der Spannungsauflösung in Korpuskularstrahl-Meßgeräten nach dem Oberbegriff des Anspruchs 1 und eine Vorrichtung zur Durchführung eines solchen Verfahrens.

Bei Elektronenstrahl-Meßgeräten ist die Spannungsauflösung
$\Delta V_{min}$ bei der Messung von Signalverläufen eine Funktion der
Bandbreite $\Delta f$ der Meßsignal-Verarbeitung und des Stromes
$I_{PE}$ der auf einen Meßpunkt auftreffenden Primärelektronen:

$$\Delta V_{min} = c \cdot \sqrt{\frac{\Delta f}{I_{PE}}}$$

mit c: Proportionalitätskonstante.   Die Messung eines Signalverlaufes an einem Meßpunkt mit einer bestimmten Spannungsauflösung erfordert einen Abgleich der beiden Parameter,
nämlich der Bandbreite $\Delta f$ und des Strahlstromes $I_{PE}$.   In
der Praxis wird dabei der Strahlstrom $I_{PE}$ konstant gehalten.

Bisher gab es nach dem Stand der Technik zwei Möglichkeiten
zur Einstellung der Spannungsauflösung.  Bei beiden Möglichkeiten wird nach dem Stand der Technik der Strahlstrom $I_{PE}$
konstant gehalten.  Nach der ersten dieser beiden aus dem
Stand der Technik bekannten Möglichkeiten wird die gewünschte
Spannungsauflösung vorgegeben und nach der oben aufgeführten
Formel sodann die notwendige Bandbreite $\Delta f$ berechnet.  Dieses bekannte Verfahren hat den Nachteil, daß die Proportionalitätskonstante c material- und topographieabhängig ist.
Außerdem ist es für eine solche Berechnung notwendig, den

My 1 Bla / 22.2.1984

Strahlstrom $I_{PE}$ zu kennen, der u.a. auch von der gewählten Breite und der Frequenz der Primärelektronenpulse in einem Elektronenstrahl-Meßgerät abhängt. Dieses Verfahren zur Berechnung der notwendigen Bandbreite $\Delta f$ ist daher in der Praxis umständlich und ungenau.

Bei einer zweiten aus dem Stand der Technik bekannten Methode zur Einstellung einer gewünschten Spannungsauflösung wird diese Spannungsauflösung von einem Operator gefühlsmäßig durch manuelle Wahl der Bandbreite $\Delta f$ eingestellt. Ein solches Verfahren ist nicht immer erfolgreich, so daß es oft notwendig ist, Signalverlaufsmessungen mit geänderter Bandbreite zu wiederholen.

Der vorliegenden Erfindung liegt die Aufgabe zugrunde, ein Verfahren der eingangs genannten Art und eine Vorrichtung zur Durchführung eines solchen Verfahrens anzugeben, mit denen eine gewünschte Spannungsauflösung einfach, zuverlässig und mit hoher Genauigkeit eingestellt werden kann.

Diese Aufgabe wird erfindungsgemäß durch ein Verfahren nach dem Anspruch 1 und durch eine Vorrichtung zur Durchführung eines solchen Verfahrens nach dem Anspruch 4 gelöst.

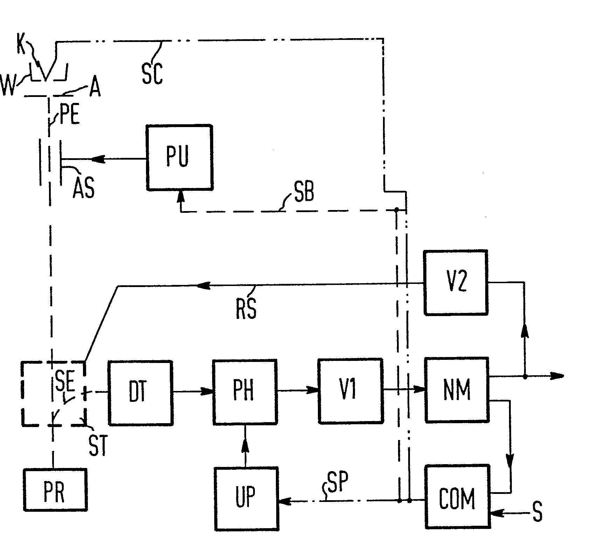

Ausgestaltungen und Vorteile der Erfindung sind in den Unteransprüchen, der Beschreibung und der Zeichnung dargestellt.

Ein erfindungsgemäßes Verfahren kann vorteilhafterweise zur automatischen Einstellung einer gewünschten Spannungsauflösung in Korpuskularstrahl-Meßgeräten verwendet werden. In einem solchen Fall übernimmt ein Rechner die Einstellung der gewünschten Spannungsauflösung.

0156005
84 P 1 155 E

Das Signalrauschen des Meßsignals kann in einem besonderen Meßgerät ermittelt werden. Das Signalrauschen kann jedoch auch mit Hilfe von Statistik-Programmen in einem Rechner ermittelt werden.

Nach Vergleich des Signalrauschens mit einer gewünschten Spannungsauflösung wird die Bandbreite der Meßsignal-Verarbeitung so verändert, daß dieses Signalrauschen kleiner oder gleich der gewünschten Spannungsauflösung ist. Die Veränderung der Bandbreite der Meßsignal-Verarbeitung kann von einem Rechner gesteuert werden, der das Meßergebnis des Signalrauschens mit dem Soll-Wert für die Spannungsauflösung vergleicht. Die Veränderung der Bandbreite der Meßsignal-Verarbeitung kann aber auch über einen Komparator erfolgen, an dessen einem Eingang das Meßergebnis des Signalrauschens eingegeben wird und an dessen anderem Eingang der Soll-Wert für die Spannungsauflösung eingegeben wird.

Um eine gute Spannungsauflösung zu erzielen, wird gewöhnlich eine möglichst kleine Pulsbreite der Primärelektronen gewählt. Die Pulsbreite der Primärelektronen beträgt dann etwa 1 ns oder etwas weniger. Gleichzeitig wird ein möglichst hoher Sondenstrom bei einer Korpuskularsonde angestrebt, um von vornherein eine möglichst kleine Spannungsauflösung zu ermöglichen. Der Strahlstrom $I_{PE}$ einer Korpuskularstrahlsonde ergibt sich als Funktion sowohl des Sondenstromes als auch der Pulsbreite als auch der Frequenz der Korpuskularpulse. Die Pulsbreite und die Frequenz der Korpuskularpulse lassen sich ihrerseits als ein sogenanntes Tastverhältnis der Korpuskularsonde darstellen. Für eine möglichst kleine Spannungsauflösung soll die Pulsbreite der Korpuskularpulse möglichst klein sein und die Frequenz der Korpuskularpulse möglichst hoch sein.

Soll eine Signalverlaufsmessung bei einer vorgegebenen Spannungsauflösung möglichst rasch durchgeführt werden, so soll die Pulsbreite der Korpuskularpulse möglichst groß und die Frequenz der Korpuskularpulse möglichst hoch sein. Falls Pulsbreiten der Korpuskularpulse in der Größenordnung von 1 ps erzeugt werden können, ist es sinnvoll, zur Einstellung einer gewünschten Spannungsauflösung nicht nur die Bandbreite der Meßsignal-Verarbeitung allein zu verändern, sondern beliebig wenigstens einen der drei Parameter: Bandbreite der Meßsignal-Verarbeitung, Tastverhältnis der Korpuskularsonde und Sondenstrom der Korpuskularsonde, zu verändern.

Die Erfindung wird anhand der Zeichnung näher erläutert.

Die Figur zeigt eine Anordnung zur Durchführung eines erfindungsgemäßen Verfahrens. Diese Anordnung ist ähnlich zu den Elektronenstrahl-Meßgeräten, wie sie aus der US-PS 4 220 853, aus der US-PS 4 277 679 oder aus der deutschen Patentanmeldung 32 35 484.3 bekannt sind. Von einem Strahlerzeugungssystem, das aus einer Kathode K, einer Wehnelt-Elektrode W und einer Anode A besteht, werden Primärelektronen PE emittiert. Diese Primärelektronen PE treffen auf einen Meßpunkt der Probe PR auf. An diesem Meßpunkt werden sowohl Sekundärelektronen SE als auch in der Figur nicht dargestellte Rückstreuelektronen und weitere Teilchen ausgelöst. Alle am Meßpunkt ausgelösten Teilchenarten können jeweils für sich zur Erzeugung eines Meßsignals herangezogen werden. Ein Teil der im Ausführungsbeispiel nach der Figur angegebenen Sekundärelektronen SE kann das Gegenfeld eines Gegenfeldspektrometers ST überwinden und wird im Detektor DT nachgewiesen. Das am Ausgang des Detektors DT anliegende Sekundärelektronen-Meßsignal wird in einem Fotomultiplier PH verstärkt. Das Ausgangssignal des Fotomultipliers PH wird in einem ersten Verstärker V1 weiter verstärkt und trifft so-

0156005

84 P 1 155 E

dann auf eine Einrichtung NM, in der das Signalrauschen des
Meßsignals ermittelt wird. An einem Ausgang dieses Gerätes
zum Ermitteln des Signalrauschens liegt das Meßsignal an,
das in einem zweiten Verstärker V2 weiter verstärkt wird und
schließlich das Potential der Gegenfeldelektrode des Gegenfeldspektrometers ST steuert. Die Rückkopplungsschaltung RS
ist notwendig für quantitative Potentialmessungen, um einen
linearen Zusammenhang zwischen Meßsignal und dem Potential
am Meßpunkt der Probe PR herzustellen. Über die Rückkopplungsschaltung RS wird die Anzahl derjenigen Sekundärelektronen SE, die das Gegenfeld des Gegenfeldspektrometers ST
überwinden können und im Detektor DT nachgewiesen werden
können, unabhängig vom Potential am Meßpunkt der Probe PR
konstant gehalten.

Von der Einrichtung NM zur Messung des Signalrauschens im
Meßsignal wird das Meßergebnis des Signalrauschens an einen
Eingang eines Komparators COM weitergegeben. Am zweiten
Eingang des Komparators COM liegt der Soll-Wert für die Spannungsauflösung vor. Der Ausgang des Komparators COM steuert
zur Einstellung der Spannungsauflösung über die Leitung SP
die Spannungsversorgung UP des Fotomultipliers PH und somit
die Bandbreite der Meßsignal-Verarbeitung im Fotomultiplier
PH. Der Ausgang des Komparators COM kann über die Leitung
SB den Pulsgenerator PU ansteuern, der seinerseits über das
Austastsystem AS die Pulsbreite und die Pulsfrequenz der
Primärelektronen PE beeinflußt. Der Ausgang des Komparators
COM kann weiterhin über eine Leitung SC die Anzahl der Korpuskeln beeinflussen, die von der Kathode K emittiert werden.

Der Komparator COM kann ohne weiteres durch einen Rechner ersetzt werden. Darüber hinaus kann auch die Kombination, bestehend aus der Einrichtung NM zum Messen des Signalrauschens
und aus dem Komparator COM, durch einen Rechner ersetzt werden.  Zu diesem Zweck muß dieser Rechner über ein Statistikprogramm verfügen, das das Signalrauschen erkennt und seiner Größe nach ermitteln kann.  Solche Statistikprogramme sind kommerziell erhältlich.

Anstelle von Elektronenstrahl-Geräten sind in entsprechender Weise auch Ionenstrahl-Geräte verwendbar.

Der Rechner COM kann auch durch einen Komparator ersetzt werden.  Als Gerät NM zur Messung des Signalrauschens kann ein Gerät der Fa. Hewlett Packard 1172B verwendet werden.

4 Patentansprüche
1 Figur

Patentansprüche:

1. Verfahren zur Einstellung der Spannungsauflösung in Korpuskularstrahl-Meßgeräten, bei dem die Bandbreite der Meßsignal-Verarbeitung verändert wird,
dadurch g e k e n n z e i c h n e t ,
- daß das Signalrauschen im Meßsignal gemessen wird,
- daß dieses Signalrauschen mit einem gewünschten Wert (S) für die Meßsignalauflösung verglichen wird und
- daß die Bandbreite der Meßsignal-Verarbeitung so verändert wird, daß das Signalrauschen des Meßsignals kleiner oder gleich dem gewünschten Wert (S) für die Meßsignalauflösung ist.

2. Verfahren nach Anspruch 1, dadurch g e k e n n - z e i c h n e t , daß auch das Tastverhältnis der Korpuskularstrahlsonde (PE) verändert wird.

3. Verfahren nach Anspruch 1 oder 2, dadurch g e k e n n - z e i c h n e t , daß auch der Sondenstrom der Korpuskularstrahlsonde (PE) verändert wird.

4. Vorrichtung zur Durchführung eines Verfahrens nach einem der Ansprüche 1 bis 3, mit einer Korpuskularstrahlsonde (PE) zur Erzeugung eines Meßsignals an einem Meßpunkt, mit einer Meßsignal-Verarbeitungseinrichtung , die eine bestimmte Bandbreite aufweist, mit einer Einrichtung (SC) zur Veränderung des Sondenstromes der Korpuskularstrahlsonde (PE), mit einer Einrichtung (SB) zur Veränderung des Tastverhältnisses der Korpuskularstrahlsonde (PE),
g e k e n n z e i c h n e t durch
eine Einrichtung (NM) zur Messung des Signalrauschens im Meßsignal, durch eine Einrichtung (COM) zum Vergleich dieses Signalrauschens mit einem vorgegebenen Wert (S) und zur Einstellung von wenigstens einem der Parameter: Bandbreite,
Sondenstrom, Tastverhältnis.

0156005

Nummer der Anmeldung

Europäisches
Patentamt

EUROPÄISCHER RECHERCHENBERICHT

EP  84 11 4710

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | IEEE JOURNAL OF SOLID-STATE CIRCUITS, vol. SC-13, no. 3, Juni 1978, Seiten 139-325; H.-P.FEUERBAUM et al.: "Quantitative measurement with high time resolution of internal waveforms on MOS RAM's using a modified scanning electron microscope" * Seite 320, linke Spalte unten bis rechte Spalte mitte; Figur 1 * | 1 | G 01 R  31/28 H 01 J  37/26 |
| A,D | DE-A-3 235 484  (SIEMENS) * Das ganze Dokument * | 1 | |

RECHERCHIERTE SACHGEBIETE (Int. Cl 4)

G 01 R
H 01 J
G 01 N

Der vorliegende Recherchenbericht wurde für alle Patentansprüche erstellt.

| Recherchenort | Abschlußdatum der Recherche | Prüfer |
|---|---|---|
| DEN HAAG | 06-06-1985 | KUSCHBERT D.E. |